# EUROPEAN PATENT APPLICATION

(11) **EP 4 325 721 A1**
(43) Date of publication of application: **21.02.2024**
(21) Application number: 22939047.1
(22) Date of filing: 28.04.2022
(51) Int. Cl.: H03F 3/68

(54) **PACKAGE STRUCTURE FOR SIGNAL AMPLIFICATION, AND SIGNAL AMPLIFIER**

(71) Applicant: Suzhou Watech Electronics Co., Ltd., Suzhou, Jiangsu 215125 (CN)
(72) Inventor: LIU, Haoyu, Shanghai 200127 (CN); ZHENG, Shuangshuang, Shanghai 200127 (CN)
(74) Representative: dompatent von Kreisler Selting Werner - Partnerschaft von Patent- und Rechtsanwälten mbB
(86) International application number: PCT/CN2022/089750
(87) International publication number: WO 2023/206195

(57) **Abstract**

Disclosed are a package structure and a signal for signal amplification. The package structure for signal amplification includes a substrate, a first transistor on the substrate, a second transistor on the substrate, and a first sub-package structure on the substrate, the first sub-package structure comprising a third transistor and a fourth transistor, an output terminal of the third transistor and an output terminal of the fourth transistor being electrically connected respectively to a control terminal of the first transistor and a control terminal of the second transistor; wherein each of the third transistor and the fourth transistor comprises a silicon-based transistor, and at least one of the first transistor and the second transistor comprises a gallium nitride transistor.

## Description

### TECHNICAL FIELD

The present disclosure relates to the technical field of signal processing, in particular to a package structure and a signal amplifier comprising the package structure for signal amplification.

### BACKGROUND

Signal amplification is often needed in the field of electronics, communication, and other technical fields, so various electronic devices contain corresponding signal amplifying circuits. The signal amplifying circuit commonly comprises transistors and necessary peripheral circuits. The transistors and peripheral circuits are fabricated on a printed circuit board which is then combined with other components of the electronic device and mounted in the housing of the electronic device. Transistors and peripheral circuits often occupy a large area on the printed circuit board, which is not conducive to the miniaturization of electronic devices. Moreover, conventional signal amplifiers still have a lot of desired improvements in efficiency and gain performance.

### SUMMARY

In view of this, the present disclosure provides a package structure and a signal amplifier comprising the package structure for signal amplification, with the expectation of overcoming some or all of the mentioned defects and other possible defects.

According to a first aspect of the present disclosure, a package structure for signal amplification is provided, which comprises: a substrate, a first transistor on the substrate, a second transistor on the substrate, and a first sub-package structure on the substrate. The first sub-package structure comprises a third transistor and a fourth transistor. An output terminal of the third transistor and an output terminal of the fourth transistor are electrically connected, respectively to a control terminal of the first transistor and a control terminal of the second transistor. At least one of the first transistor and the second transistor comprises a gallium nitride transistor. Each of the third transistor and the fourth transistor comprises a silicon-based transistor.

According to some embodiments of the present disclosure, the package structure comprises a first signal input terminal and a second signal input terminal. The first sub-package structure further comprises an input circuit. The input circuit is electrically connected, respectively to the first signal input terminal, the second signal input terminal, the control terminal of the third transistor and the control terminal of the fourth transistor, to transmit AC signals input from the first signal input terminal and the second signal input terminal, respectively to the control terminal of the third transistor and the control terminal of the fourth transistor. The input circuit is further configured to transmit corresponding DC voltages respectively to the control terminal of the third transistor and the control terminal of the fourth transistor.

According to some embodiments of the present disclosure, the package structure further comprises a first DC voltage input terminal and a second DC voltage input terminal. The input circuit comprises a first input sub-circuit and a second input sub-circuit, the first input sub-circuit comprises a first capacitor and a first inductor electrically connected in series between a first signal input terminal and the control terminal of the third transistor, a second inductor electrically connected between the control terminal of the third transistor and a first DC voltage input terminal, and a second capacitor electrically connected between the first DC voltage input terminal and the ground terminal. The second input sub-circuit is symmetrical with the first input sub-circuit and electrically connected, respectively to the second signal input terminal, the second DC voltage input terminal, and the control terminal of the fourth transistor.

According to some embodiments of the present disclosure, the package structure further comprises a second sub-package structure on the substrate. The second sub-package structure comprises an intermediate transmit circuit. The intermediate transmit circuit is electrically connected, respectively to the output terminal of the third transistor, the output terminal of the fourth transistor, the control terminal of the first transistor, and the control terminal of the second transistor, to transmit an output signal of the third transistor and an output signal of the fourth transistor respectively to the first transistor and the second transistor. The intermediate transmit circuit is further configured to transmit the corresponding DC voltage respectively to the output terminal of the third transistor, the output terminal of the fourth transistor, the control terminal of the first transistor, and the control terminal of the second transistor.

According to some embodiments of the present disclosure, the package structure further comprises a third DC voltage input terminal, a fourth DC voltage input terminal, a fifth DC voltage input terminal, and a sixth DC voltage input terminal. The intermediate transmit circuit comprises a first intermediate sub-circuit and a second intermediate sub-circuit. The first intermediate sub-circuit comprises a third inductor and a third capacitor electrically connected in series between the output terminal of the third transistor and the control terminal of the first transistor, a fourth inductor electrically connected between a node between the third inductor and the third capacitor and the third DC voltage input terminal, a fourth capacitor electrically connected between the third DC voltage input terminal and a ground terminal, a fifth inductor electrically connected between a node between the third capacitor and the control terminal of the first transistor and the fourth DC voltage input terminal, and a fifth capacitor electrically connected between the fourth DC voltage input terminal and the ground terminal. The second intermediate sub-circuit is symmetrical with the first intermediate sub-circuit and is electrically connected, respectively to the output terminal of the fourth transistor, the control terminal of the second transistor, a fifth DC voltage input terminal, and a sixth DC voltage input terminal.

According to some embodiments of the present disclosure, the first intermediate sub-circuit further comprises a sixth capacitor electrically connected between the node between the third capacitor and the control terminal of the first transistor and the ground terminal, a seventh sensor electrically connected between the node between the third capacitor and the control terminal of the first transistor and the third capacitor, and a seventh capacitor electrically connected between the node between the third capacitor and the seventh sensor and the ground terminal.

According to some embodiments of the present disclosure, the package structure further comprises a third sub-package structure and a signal output terminal on the substrate. The third sub-package structure comprises an output circuit electrically connected, respectively to the signal output terminal, the output terminal of the first transistor, and the output terminal of the second transistor, to combine the signal of the output terminal of the first transistor and the signal of the output terminal of the second transistor and transmit to the signal output terminal. The output circuit is further configured to transmit the corresponding DC voltage respectively to the control terminal of the first transistor and the control terminal of the second transistor.

According to some embodiments of the present disclosure, the package structure further comprises a seventh DC voltage input terminal, and the output circuit comprises a transmission line, a first output capacitor, a first conductive node, and a second conductive node. A first end of the transmission line is electrically connected to the first conductive node via at least one first bond wire. The first conductive node is electrically connected to the output terminal of the first transistor via at least one second bond wire. A second end of the transmission line is electrically connected to the second conductive node via at least one third bond wire. A first end of the first output capacitor is electrically connected to the second conductive node. A second terminal of the first output capacitor is electrically connected to the ground terminal. An output terminal and a signal output terminal of the second transistor are electrically connected to the second conductive node respectively via at least one fourth bond wire and at least one fifth bond wire.

According to some embodiments of the present disclosure, the transmission line comprises a strip line, a coplanar waveguide, a substrate integrated waveguide, or a microstrip line.

According to some embodiments of the present disclosure, the package structure further comprises a signal output, a second output capacitor, and a third conductive node on the substrate. The output terminal of the first transistor is electrically connected to the third conductive node via at least one sixth bond wire. The third conductive node, the output terminal of the second transistor, and the signal output terminal are electrically connected to a first terminal of the second output capacitor respectively via at least one seventh bond wire, at least one eighth bond wire, and at least one ninth bond wire. A second terminal of the second output capacitor is electrically connected to the ground terminal.

According to some embodiments of the present disclosure, the intermediate transmit circuit comprises a first intermediate sub-circuit and a second intermediate sub-circuit. The first intermediate sub-circuit is configured to transmit an output signal of the third transistor to the first transistor. The second intermediate sub-circuit is configured to transmit an output signal of the fourth transistor to the second transistor. An output terminal of the first intermediate sub-circuit and an output terminal of the second intermediate sub-circuit are electrically connected to the first transistor and the second transistor respectively via at least one interstage bond wire. The intermediate transmit circuit comprises at least one sixth capacitor. A first terminal of the sixth capacitor is electrically connected to the ground terminal. A second terminal of the sixth capacitor is electrically connected to the output terminal of the first intermediate sub-circuit or the output terminal of the second intermediate sub-circuit.

According to some embodiments of the present disclosure, the package structure comprises a radio-frequency signal input terminal. The first sub-package structure further comprises a power divider. The power divider is electrically connected, respectively to the radio-frequency signal input terminal, the control terminal of the third transistor, and the control terminal of the fourth transistor, to respectively allocate the radio-frequency signal from the radio-frequency signal input terminal to the third transistor and the fourth transistor.

According to some embodiments of the present disclosure, the package structure further comprises at least one first additional transistor and at least one second additional transistor corresponding to the at least one first additional transistor. An output terminal of each first additional transistor is electrically connected to a control terminal of a corresponding second additional transistor, so that the corresponding second additional transistor can amplify a signal at the output terminal of the first additional transistor. The first additional transistor comprises a silicon-based transistor, and the second additional transistor comprises a gallium nitride transistor. The first additional transistor is integrated within the first sub-package structure.

The embodiments of the present disclosure provide a signal amplifier comprising a carrier board and a package structure in any of the embodiments on the carrier board.

These and other advantages of the present disclosure will become apparent from the embodiments described below and will be elucidated with reference to the embodiments described below.

### BRIEF DESCRIPTION OF THE DRAWINGS

The embodiments of the present disclosure will now be described in more detail and with reference to the accompanying drawings, where:
Fig. 1 illustrates a schematic diagram of the main elements comprised in a package structure according to an embodiment of the present disclosure.
Fig. 2 illustrates a schematic diagram of the main elements comprised in a package structure according to another embodiment of the present disclosure.
Fig. 3 illustrates a schematic diagram of the main elements comprised in a package structure according to another embodiment of the present disclosure.
Fig. 4 illustrates a schematic diagram of the main elements comprised in a package structure according to another embodiment of the present disclosure.
Fig. 5 illustrates an exemplary embodiment of the package structure corresponding to the embodiment shown in Fig. 3.
Fig. 6 illustrates an exemplary embodiment of the package structure corresponding to the embodiment shown in Fig. 4.
Fig. 7 illustrates another exemplary embodiment of the package structure corresponding to the embodiment shown in Fig. 4.
Fig. 8 illustrates another exemplary embodiment of the package structure corresponding to the embodiment shown in Fig. 3.
Fig. 9 illustrates another exemplary embodiment of a first intermediate sub-circuit or a second intermediate sub-circuit comprised in an intermediate transmit circuit which can be employed to the package structure shown in Fig. 3 or Fig. 4.
Fig. 10 illustrates a schematic diagram of the main elements comprised in the package structure according to yet another embodiment of the present disclosure.
Fig. 11 illustrates a schematic structural diagram of a signal amplifier according to the embodiment of the present disclosure.
Figs. 12 to 14 illustrates gain characteristics and efficiency characteristics of the signal amplifier with the package structure provided by the embodiment of Fig. 5 of the present disclosure.
Fig. 15 illustrates a schematic diagram of the main elements comprised in a package structure according to yet another embodiment of the present disclosure.

### DETAILED DESCRIPTION OF THE EMBODIMENTS

The following description provides specific details of various embodiments of the present disclosure so that those skilled in the art can fully understand and implement the various embodiments of the present disclosure. In some cases the present disclosure does not show or detail some structures or functions well known in the art to avoid such unnecessary descriptions obscuring the description of embodiments of the present disclosure. The technical aspects of the present disclosure can be embodied in many different forms and purposes and should not be limited to the embodiments set forth herein. These embodiments are provided to make the technical scheme of the present disclosure clear and complete, but the embodiments are not limited to the scope of protection of the patent application.

Herein some of the terms referred to in the embodiments of the present disclosure will first be explained so as to facilitate the understanding of those skilled in the art.

The "package structure" mentioned in this specification refers to the products formed by different components being fabricated on the same substrate and sealed in the same package housing via the integration process, and the package structure can be in the form of chips. Likewise, the "sub-package structure" referred to herein has characteristics similar to those of the above-mentioned package structure and can take the form of a chip, but the "sub-package structure" is fabricated on the substrate of the above-mentioned package structure and sealed therein, that is, the sub-package structure can be regarded as a component of the package structure.

A transistor referred to herein is a semiconductor device comprising three terminals, which can comprise a gate, a source, and a drain, or which can comprise a base, a collector, and an emitter. The control terminal of the transistor mentioned in this specification refers to the gate or the base, and the output terminal of the transistor refers to one of the source and the drain, or one of the collector and the emitter.

The "silicon transistor" mentioned herein refers to a transistor whose current conduction channel mainly comprises silicon semiconductor material. Examples of silicon transistors comprise but are not limited to lateral double diffused metal oxide semiconductor (LDMOS) transistors. The gallium nitride transistor refers to a transistor whose current conduction channel mainly comprises gallium nitride semiconductor material. Examples of gallium nitride transistors comprise but are not limited to high electron mobility transistors (HEMT).

The term "symmetrical" referred to herein is to describe the similarity between the configurations of two sub-circuits. "Two symmetrical sub-circuits" means that the two sub-circuits comprise the same type of electrical components, the same number of electrical components of the same type in the two sub-circuits, and the same connection relationship between the various electrical components in the two sub-circuits. In other words, the two symmetrical sub-circuits can mean that the two sub-circuits have the same circuit configuration without considering factors such as the parameters of the electrical components.

The "ground terminal" mentioned in this specification refers to the position with reference ground potential in the package structure, and the implementation of the ground terminal comprises but is not limited to connectors, nodes, or electrical connecting wires.

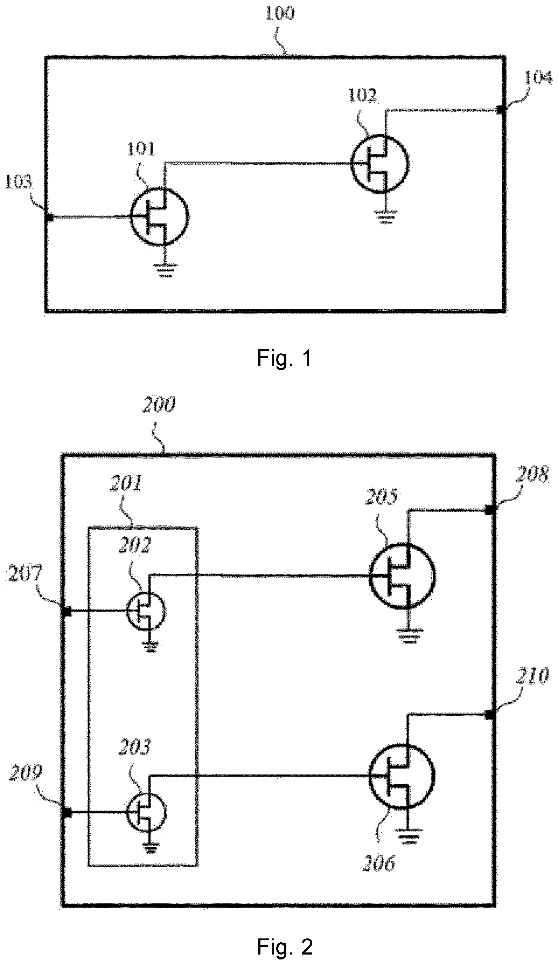

Fig. 1 is a schematic diagram of a package structure provided according to an embodiment of the present disclosure. As shown in Fig. 1, the package structure 100 comprises at least a first transistor 101 a second transistor 102, a signal input terminal 103, and a signal output terminal 104. A control terminal of the first transistor 101 is electrically connected to the signal input terminal 103. An output terminal of the first transistor 101 is electrically connected to a control terminal of the second transistor 102. The output terminal of the second transistor 102 is electrically connected to the signal output terminal 104. In one example, the outputs of the first transistor 101 and the second transistor 102 respectively are drains of the first transistor 101 and drains of the second transistor 102, and the sources of the first transistor 101 and the second transistor 102 are electrically connected to the ground terminal. Thus the first transistor 101 and the second transistor 102 can realize a two-stage amplification of the input signal supplied from the signal input terminal 103. In the embodiment of Fig. 1, the first transistor 101 and the second transistor 102 are based on the same substrate process. For example, both transistors 101 and 102 are silicon transistors, or both transistors 101 and 102 are gallium nitride transistors. The first transistor 101 and the second transistor 102 realize two-stage amplification of the input signal, so that the gain of the signal amplifier with the package structure shown in Fig. 1 is improved, and the two transistors are integrated in the same package structure, which is beneficial to reduce the size of the signal amplifier.

However, the inventors of the present invention have found that the signal amplifier with the package structure of the embodiment shown in Fig. 1 still has obvious deficiencies in efficiency gain linearity and the like. For example, in the case where both transistors 101 and 102 are silicon transistors, the efficiency of the signal amplifier is not improved by using two cascaded transistors, and in the case where both transistors 101 and 102 are gallium nitride transistors, the signal amplifier has poor gain linearity.

Fig. 2 is a schematic diagram of a package structure provided according to another embodiment of the present disclosure. As shown in Fig. 2, the package structure 200 for signal amplification, comprises a first transistor 205, a second transistor 206, and a first sub-package structure 201. The package structure 200 further comprises a substrate (not shown in Fig. 2) on which a first transistor 205, a second transistor 206 and a first sub-package structure 201 are all located. The material of the substrate can comprise diamond or metal and the like for carrying the first transistor 205, the second transistor 206, and the first sub-package structure 201. The first sub-package structure 201 at least comprises a third transistor 202 and a fourth transistor 203. An output terminal of the third transistor 202 is electrically connected to a control terminal of the first transistor 205, so that the first transistor 205 can amplify a signal at an output terminal of the third transistor 202. An output terminal of the fourth transistor 203 is electrically connected to a control terminal of the second transistor 206, so that the second transistor 206 can amplify a signal at an output terminal of the fourth transistor 203. Also at least one of the first transistor 205 and the second transistor 206 comprises a gallium nitride transistor, and the third transistor 202 and the fourth transistor 203 each comprise a silicon-based transistor. That is, both the first transistor 205 and the second transistor 206 may comprise a gallium nitride transistor. Optionally, one of the first transistor 205 and the second transistor 206 can comprise a gallium nitride transistor, and the other of the first transistor 205 and the second transistor 206 can comprise other types of transistors, such as silicon-based transistors.

In the embodiment shown in Fig. 2, the package structure 200 actually comprises two signal amplifying paths, the first signal amplifying path comprising a signal input terminal 207, the third transistor 202, the first transistor 205, and a signal output 208, and the second signal amplifying path comprising a signal input 209, the fourth transistor 203, the second transistor 206, and a signal output 210. In each signal amplifying path, at least one of the post-stage transistors 205, 206 providing the output signal is a gallium nitride transistor, so that the high power density and high efficiency of the gallium nitride transistor can be fully utilized to realize the effective amplification of the input signal, while the pre-stage transistors 202, 203 is a silicon-based transistor, which can fully utilize the high gain linearity of the silicon-based transistor, and is beneficial to improve the overall gain linearity of the signal amplifying path. In the embodiment of Fig. 2, the third transistor 202 and the fourth transistor 203 are integrated into the first sub-package structure 201, for example, can be fabricated into a smaller integrated circuit chip, which is beneficial to further reduce the size and volume of the package structure and improve the integration level of the signal amplifying circuit. Further, integrating the third transistor 202 and the fourth transistor 203 which are both silicon-based transistors into the first sub-package structure 201 does not cause a high cost of the package structure 200.

The package structure 200 shown in Fig. 2 comprises two signal inputs 207, 209 and two signal outputs 208, 210, and the package structure 200 can have rich implementation scenarios. For example, different signals inputted from the signal input terminals 207 and 209 can be amplified and corresponding amplified signals can be respectively output from the signal output terminals 208 and 210. Optionally, a peripheral circuit can be provided outside the package structure 200 to combine the output signals of the signal output terminals 208 and 210. The present disclosure does not limit any particular implementation of the package structure 200. Of course, it will be understood that, in addition to the four transistors, the package structure 200 can comprise other electronic components required for the proper operation of the four transistors which are not shown in Fig. 2 for the sake of brevity.

In the following description, each of the first transistor and the second transistor comprises a gallium nitride transistor as an example.

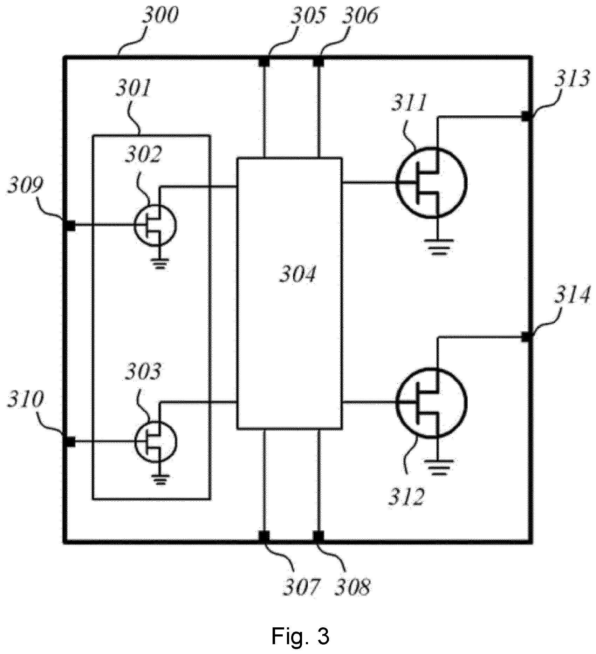

Fig. 3 is a schematic diagram of a package structure provided according to another embodiment of the present disclosure. The main difference between the package structure 300 and the package structure 200 shown in Fig. 2 is that the package structure 300 further comprises a second sub-package structure 304 on the substrate, and the second sub-package structure 304 comprises an intermediate transmit circuit. The intermediate transmit circuit is electrically connected, respectively to an output terminal of a third transistor 302, an output terminal of a fourth transistor 303, a control terminal of a first transistor 311, and a control terminal of a second transistor 312, to transmit the output signals of the third transistor 302 and the fourth transistor 303 respectively to the first transistor 311 and the second transistor 312. The intermediate transmit circuit is further configured to supply corresponding DC voltages respectively to an output of the third transistor 302, an output of the fourth transistor 303, a control terminal of the first transistor 311, and a control terminal of the second transistor 312. In the embodiment shown in Fig. 3, the intermediate transmit circuit is fabricated in the second sub-package structure 304, that is, the intermediate transmit circuit is in the form of an integrated circuit chip, which can further reduce the size of the package structure and improve the integration level of electronic components inside the package structure. In some embodiments, the intermediate transmit circuit inside the second sub-package structure 304 has functions both to provide a corresponding DC voltage and to achieve impedance matching on the signal amplifying path. Specifically, in a case where the signal amplifier comprising the package structure 300 is operating, the intermediate transmit circuit can match the impedance at the output terminal of the third transistor 302 and the impedance at the output terminal of the fourth transistor 303 respectively to the control terminal of the first transistor 311 and the control terminal of the second transistor 312, while further supplying corresponding DC voltages respectively to the output terminal of the third transistor 302, the output terminal of the fourth transistor 303, the control terminal of the first transistor 311 and the control terminal of the second transistor 312. As shown in Fig. 3, the package structure 300 comprises four DC voltage input terminals 305, 306, 307, and 308, each electrically connected to the intermediate transmit circuit to transmit the corresponding DC voltage. In some embodiments, the intermediate transmit circuit can comprise passive components such as inductors, capacitors, resistors, and the like, and specific examples of the intermediate transmit circuit will be described in further detail below.

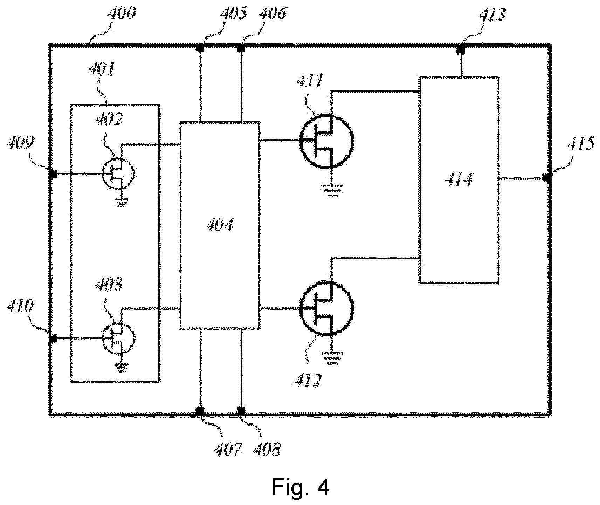

Fig. 4 is a schematic diagram of a package structure provided according to another embodiment of the present disclosure. As shown in Fig. 4, the package structure 400 comprises a first sub-package structure 401, a second sub-package structure 404, a third sub-package structure 414, and a signal output terminal 415 on a substrate. The first sub-package structure 401 and the second sub-package structure 404 can be similar to the first sub-package structure 301 and the second sub-package structure 304 in Fig. 3, and the first transistor 411 and the second transistor 412 are gallium nitride transistors, which are similar to the first transistor 311 and the second transistor 312 in Fig. 3. The third sub-package structure 414 comprises an output circuit electrically connected respectively to the signal output terminal 415, an output terminal of the first transistor 411, and an output terminal of the second transistor 412, to combine the signal of the output terminal of the first transistor 411 and the signal of the output terminal of the second transistor 412 and transmit to the signal output terminal 415. The output circuit is further configured to transmit corresponding DC voltages to the output terminal of the first transistor 411 and the output terminal of the second transistor 412. Specific examples of the output circuit will be described in further detail below.

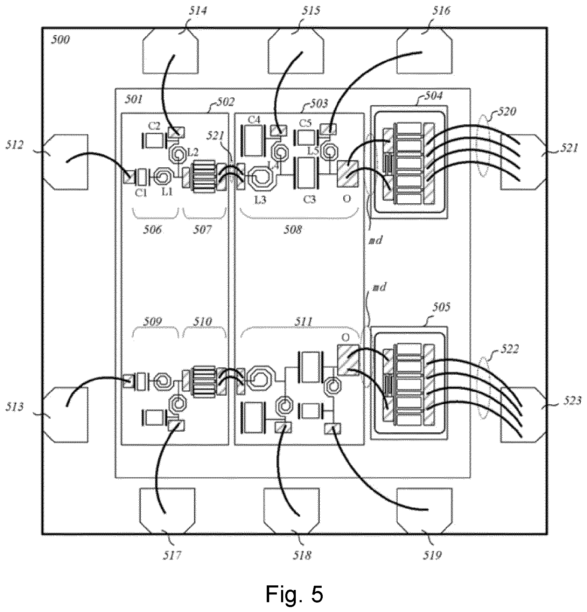

Fig. 5 schematically illustrates the main elements of a package structure 500 according to yet another embodiment of the disclosure. As shown in Fig. 5, the package structure 500 comprises a first sub-package structure 502, a second sub-package structure 503, a first transistor 504, and a second transistor 505. The first sub-package structure 502, the second sub-package structure 503, the first transistor 504 and the second transistor 505 can be formed on a substrate 501. In addition to a third transistor 507 and a fourth transistor 510, the first sub-package structure 502 further comprises an input circuit. As shown in Fig. 5, the package structure 500 comprises a first signal input terminal 512 and a second signal input terminal 513, and the input circuits inside the first sub-package structure 502 are electrically connected, respectively to the first signal input terminal 512, the second signal input terminal 513, a control terminal of the third transistor 507 and a the control terminal of the fourth transistor 510, to respectively transmit AC signals from the first signal input terminal 512 and the second signal input terminal 513 to the third transistor 507 and the fourth transistor 510. The input circuit is further configured to transmit corresponding DC voltages respectively to the control terminal of the third transistor 507 and the control terminal of the fourth transistor 510.

Further, as shown in Fig. 5, the package structure 500 further comprises a first DC voltage input terminal 514, and a second DC voltage input terminal 517. The input circuit comprises a first input sub-circuit 506 and a second input sub-circuit 509. The first input sub-circuit comprises a first capacitor C1 and a first inductor L1 electrically connected in series between the first signal input terminal 512 and the control terminal of the third transistor 507, a second inductor L2 electrically connected between the control terminal of the third transistor 507 and the first DC voltage input terminal 514, and a second capacitor C2 electrically connected between the first DC voltage input terminal 514 and the ground terminal. Both the first capacitor C1 and the second capacitor C2 in the first input sub-circuit are capable of transmitting an AC signal and blocking a DC signal. The AC signal on the signal path from the first DC voltage input 514 to the control terminal of the third transistor 507 can be filtered out via the second capacitor C2 electrically connected to the ground terminal, so that the first DC voltage input 514 can transmit a corresponding DC voltage to the control terminal of the third transistor 507 to meet the requirement of normal operation of the third transistor 507. Further, it can be understood that, according to the signal source supplying the input signal to the first signal input terminal 512, the parameters of the first capacitor C1, the first inductor L1, the second capacitor C2, and the second inductor L2 can be designed, to achieve impedance matching on the AC signal transmission path between the first signal input terminal 512 and the third transistor 507. The second input sub-circuit 509 is symmetrical with the first input sub-circuit 506 and is electrically connected, respectively to a second signal input 513, a second DC voltage input 517 and the control terminal of the fourth transistor 510. As previously explained, the second input sub-circuit 509 is symmetrical with the first input sub-circuit 506, meaning that the second input sub-circuit 509 comprises the same type of electronic components as the first input sub-circuit 506, and the electrical connections between these electronic components are the same as the first input sub-circuit 506. As shown in Fig. 5, the second input sub-circuit 509 further comprises two capacitors and two inductors and is not described here.

Continuing with reference to Fig. 5, the package structure further comprises a third DC voltage input terminal 515, a fourth DC voltage input terminal 516, a fifth DC voltage input terminal 518, and a sixth DC voltage input terminal 519. The intermediate transmit circuit comprises a first intermediate sub-circuit 508 and a second intermediate sub-circuit 511. The first intermediate sub-circuit 508 comprises a third inductor L3 and a third capacitor C3 electrically connected in series between the output terminal of the third transistor 507 and the control terminal of the first transistor 504, a fourth inductor L4 electrically connected between a node between the third inductor L3 and the third capacitor C3 and a third DC voltage input terminal 515, a fourth capacitor C4 electrically connected between the third DC voltage input terminal 515 and the ground terminal, a fifth inductor L5 electrically connected between a node O between the third capacitor C3 and the control terminal of the first transistor 504 and the fourth DC voltage input terminal 516, and a fifth capacitor C5 electrically connected between the fourth DC voltage input terminal 516 and the ground terminal. The third DC voltage input terminal 515 can transmit a DC voltage to the output terminal (e.g. drain) of the third transistor via the fourth sensor L4 and the third sensor L3. Likewise, the fourth DC voltage input terminal 516 can transmit a corresponding DC voltage to the control terminal of the first transistor 504 via the fifth inductor L5. The parameters of the third inductor L3, the third capacitor C3, the fourth capacitor C4, the fifth capacitor C5, the fourth inductor L4, and the fifth inductor L5 can be designed, to achieve impedance matching on the signal transmission path from the output terminal of the third transistor to the control terminal of the first transistor. As shown in Fig. 5, the second intermediate sub-circuit 511 and the first intermediate sub-circuit 508 are symmetrical, and electrically connected respectively to the output terminal of the fourth transistor 510, the control terminal of the second transistor 505, a fifth DC voltage input terminal 518 and a sixth DC voltage input terminal 519. The output terminal of the first transistor 504 and the output terminal of the second transistor 505 can be electrically connected to output terminals 521 and 523 of the package structure 500 respectively via bond wires. The bond wires referred to herein refer to wires that serve as electrical signal transmissions inside a package structure, and materials of bond wires comprise but are not limited to gold, silver, aluminum, etc.

For the embodiment shown in Fig. 5, the input circuit and the intermediate transmit circuit not only realize the overall consideration of AC signal transmission and DC voltage transmission, but also simplify the circuit configuration. Furthermore, the main electronic components in the input circuit and the intermediate transmit circuit are respectively integrated into the first sub-package structure 502 and the second sub-package structure 503, which can significantly reduce the overall size of the package structure 500, to be beneficial to reduce in the volume of the electronic device to which the package structure 500 is employed.

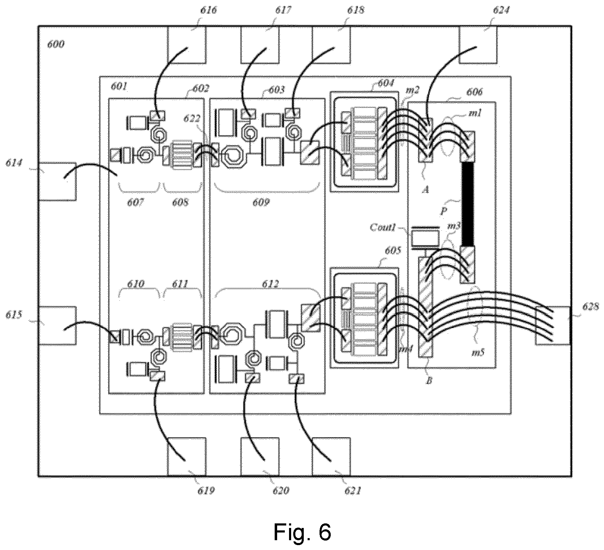

Fig. 6 is a schematic diagram of a package structure 600 provided according to yet another embodiment of the present disclosure. As shown in Fig. 6, the package structure 600 can comprise a first sub-package structure 602, a second sub-package structure 603, a first transistor 604 and a second transistor 605, which are carried by a substrate 601 and respectively similar to the first sub-package structure 502, the second sub-package structure 503, the first transistor 504 and the second transistor 505 in Fig. 5. The package structure 600 further comprises a third sub-package structure 606 carried by the substrate 601 and a signal output terminal 628. The third sub-package structure 606 comprises an output circuit electrically connected respectively to the signal output 628, an output terminal of the first transistor 604, and an output terminal of the second transistor 605, to combine the signal from the output terminal of the first transistor 604 and the signal from the output terminal of the second transistor 605 and transmit to the signal output terminal 628. The output circuit is further configured to transmit corresponding DC voltages respectively to the output terminal of the first transistor 604 and the output terminal of the second transistor 605.

Further, with reference to Fig. 6, the package structure 600 further comprises a seventh DC voltage input terminal 624. The output circuit comprises a transmission line P, a first output capacitor Cout1, a first conductive node A, and a second conductive node B. A first end of the transmission line P is electrically connected to the first conductive node A via at least one first bond wire m1. The first conductive node A is electrically connected to the output terminal of the first transistor 604 via at least one second bond wire m2. A second end of the transmission line P is electrically connected to the second conductive node B via at least one third bond wire m3. A first end of the first output capacitor Cout1 is electrically connected to the second conductive node B. A second end of the first output capacitor Cout1 is electrically connected to the ground terminal. An output terminal of the second transistor 605 and a signal output terminal 628 are electrically connected to the second conductive node B respectively via at least one fourth bond wire m4 and at least one fifth bond wire m5. The embodiment shown in Fig. 6 implements one example of a Doherty Amplifier, where a first input sub-circuit 607, a third transistor 608, a first intermediate sub-circuit 609, the first transistor 604 can form a main amplifying path, a second input sub-circuit 610, a fourth transistor 611, a second intermediate sub-circuit 612, the second transistor 605 can form an auxiliary amplifying path, and the output circuit inside the third sub-package structure 606 can combine amplified signals of the main amplifying path and the auxiliary amplifying path. It can be understood that, based on the impedance matching theory, the parameters of the transmission line P1, the first output capacitor Cout1, and each of the bond wires m1 to m5 in the output circuit can be designed, to realize impedance matching on the transmission path from the combined node B of the main amplifying path and the auxiliary amplifying path to the signal output terminal 628. In addition, the seventh DC voltage input 624 is electrically connected respectively to the output terminal of the first transistor 604 and the output terminal of the second transistor 605, and can simultaneously supply the DC voltage required for normal operation of the first transistor 604 and the second transistor 605 to the first transistor 604 and the second transistor 605.

For the embodiment shown in Fig. 6, integrating the various elements comprised in the output circuit inside the third sub-package structure 606 can facilitate a reduction in the overall size of the package structure 600, thereby facilitating a reduction in the volume of the electronic device to which the package structure 600 is employed. The transmission line P comprises any one of a stripline, a coplanar waveguide, a substrate integrated waveguide, or a microstrip line.

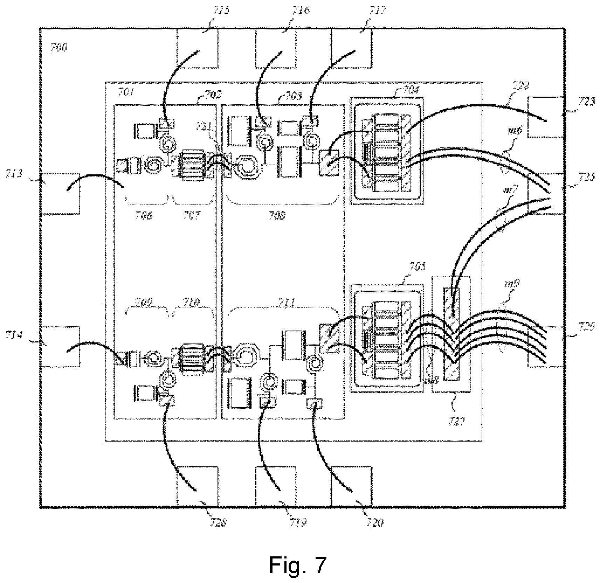

Fig. 7 is a schematic diagram of a package structure 700 according to yet another embodiment of the present disclosure. The package structure 700 shown in Fig. 7 can comprise a substrate 701, a first sub-package structure 702, a second sub-package structure 703, a first transistor 704, and a second transistor 705. The first sub-package structure 702, the second sub-package structure 703, the first transistor 704 and the second transistor 705 are similar respectively to the first sub-package structure 602, the second sub-package structure 603, the first transistor 604, and the second transistor 605 in Fig. 6. Unlike the package structure 600 shown in Fig. 6, the package structure 700 does not comprise the third sub-package structure 600 and instead employs a combination of bond wires and capacitors in place of the third sub-package structure 600. As shown in Fig. 7, the package structure 700 further comprises a signal output terminal 729, a second output capacitor 727, and a third conductive node 725. The output terminal of the first transistor 704 is electrically connected to the third conductive node 725 via at least one sixth bond wire m6. The third conductive node 725, the output terminal of the second transistor 705, and the signal output terminal 729 are electrically connected to a first end of the second output capacitor 727 respectively via at least one seventh bond wire m7, at least one eighth bond wire m8, and at least one ninth bond wire m9. A second end of the second output capacitor 727 is electrically connected to the ground terminal. The embodiment shown in Fig. 7 provides a package structure 700 with a more simplified output circuit and eliminates the cost of fabricating a third sub-package structure. Although in Fig. 7 the third conductive node 725 is shown to be located on the outer periphery of the substrate 701, the third conductive node 725 can serve as an output terminal of the package structure 700. In other embodiments, the third conductive node 725 can be located inside the package structure 700, for example, on the substrate 701.

The intermediate transmit circuit inside the second sub-package structure comprises a first intermediate sub-circuit and a second intermediate sub-circuit, as previously exemplified with reference to Figs. 5 to 7. The first intermediate sub-circuit is configured to transmit an output signal of the third transistor to the first transistor. The second intermediate sub-circuit is configured to transmit an output signal of the fourth transistor to the second transistor. An output terminal of the first intermediate sub-circuit and an output terminal of the second intermediate sub-circuit are electrically connected to the first transistor and the second transistor respectively via at least one interstage bond wire. For example, the interstage bond wire md shown in Fig. 5. The interstage bond wire md mentioned herein is not meant to be a special property of the bond wire but is intended to be distinguished by name from other bond wires mentioned herein. Further, in some embodiments, the intermediate transmit circuit comprises at least one sixth capacitor. A first end of the sixth capacitor is electrically connected to the ground terminal, and a second end of the sixth capacitor is electrically connected to an output terminal of the first intermediate sub-circuit or an output terminal of the second intermediate sub-circuit. Therefore, the sixth capacitor and the parasitic inductance of the interstage bond wire can form a resonant network, thereby effectively controlling the harmonic impedance on the signal amplifying path, which is beneficial to improving the output power and efficiency of the amplifier with the package structure. The equivalent inductance value of the interstage bond wires can be adjusted by adjusting the number, length, height and other parameters of the interstage bond wires, so as to realize the desired harmonic control. Therefore, the inductor for harmonic control does not need to be specially arranged in the package structure, and the size of the package structure is not increased while harmonic control is realized.

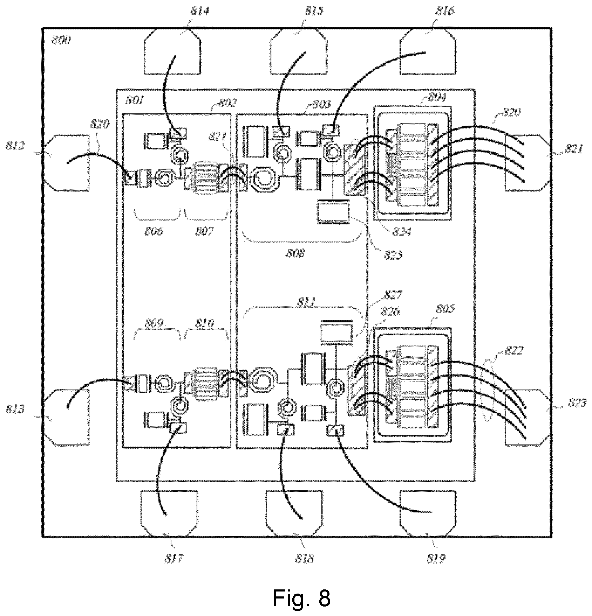

Fig. 8 shows an example in which the intermediate transmit circuit of the package structure comprises the sixth sensor described above. The corresponding internal elements of the package structure 800 shown in Fig. 8 substantially correspond to the package structure 500 shown in Fig. 5. In the package structure shown in Fig. 8, the intermediate transmit circuit comprises a first intermediate sub-circuit 808 and a second intermediate sub-circuit 811. An output terminal of the first intermediate sub-circuit 808 and an output terminal of the second intermediate sub-circuit 811 can be electrically connected to the first transistor 804 and the second transistor 805 respectively via at least one interstage bond wire 824, 826. The first intermediate sub-circuit comprises a capacitor 825 and the second intermediate sub-circuit comprises a capacitor 827 corresponding to the sixth capacitor described above.

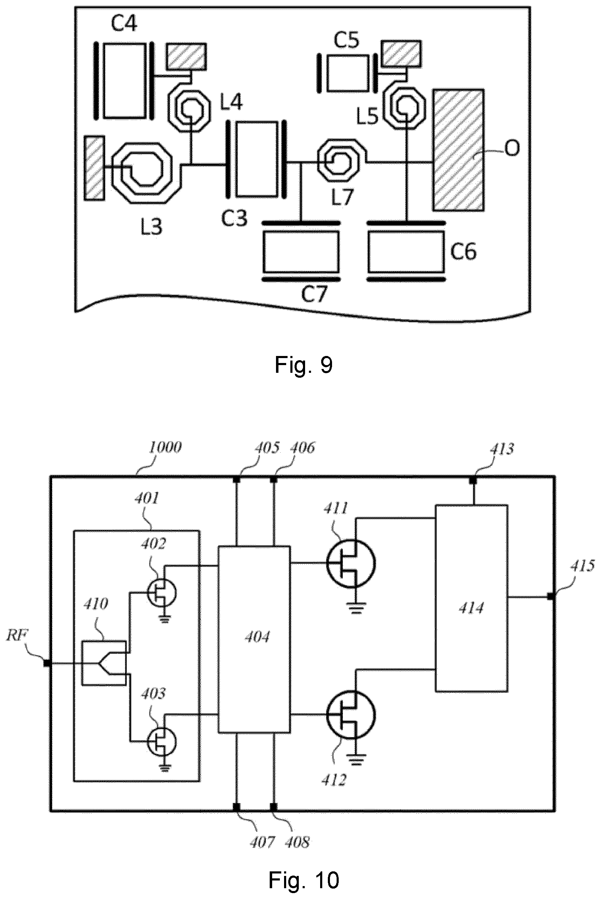

Fig. 9 schematically illustrates an intermediate sub-circuit in an intermediate transmit circuit in a package structure according to another embodiment of the disclosure. Compared with the embodiments shown in Figs. 5 to 7, the intermediate sub-circuit (e.g. the aforementioned first intermediate sub-circuit or second intermediate sub-circuit) further comprises a sixth capacitor C6 electrically connected between a node O between the third capacitor C3 and the control terminal of the first transistor and the ground terminal, a seventh sensor L7 electrically connected between a node O between the third capacitor C3 and the control terminal of the first transistor and the third capacitor C3, and a seventh capacitor C7 electrically connected between a node between the third capacitor C3 and the seventh sensor L7 and the ground terminal. As mentioned above, the sixth capacitor C6 here can cooperate with the aforementioned interstage bond wire to form a resonant network to realize harmonic control. In addition, the seventh sensor and the seventh capacitor can increase the bandwidth ratio of the amplifier with the package structure of the embodiment of the present disclosure and improve the data transmission capability of the amplifier.

Fig. 10 schematically illustrates the main elements of a package structure according to another embodiment of the disclosure. As shown in Fig. 10, the package structure 1000 is similar to the package structure 400 shown in Fig. 4 and comprises a first sub-package structure 401, a second sub-package structure 404, a third sub-package structure 414, and a signal output 415 on a substrate. The second sub-package structure 404 comprises an intermediate transmit circuit. The third sub-package structure 414 comprises an output circuit. The package structure 1000 further comprises a radio-frequency signal input terminal RF. The first sub-package structure 401 further comprises a power divider 410. The power divider 410 is electrically connected respectively to a radio-frequency signal input terminal RF, the control terminal of the third transistor 402, and the control terminal of the fourth transistor 403, to respectively allocate a radio-frequency signal from the radio-frequency signal input terminal RF to the third transistor 402 and the fourth transistor 403. The power divider can divide the radio-frequency signal supplied from the radio-frequency signal input terminal RF into two power signals with equal or unequal power energies and respectively supply to the third transistor 402 and the fourth transistor 403. The two power signals are respectively amplified by two amplifying paths and then combined by the output circuit in the third sub-package structure 414. The combined signal is output from the signal output terminal 415. The package structure shown in Fig. 10 is implemented in a Doherty Amplifier. The main components of the Doherty Amplifier are integrated into the package structure, and except for some necessary DC voltage signal terminals, the pins of the whole package structure only comprise the radio-frequency signal input terminal RF and the signal output terminal 415. The integration level of the package structure of the Doherty Amplifier is improved and the pin layout can be simplified.

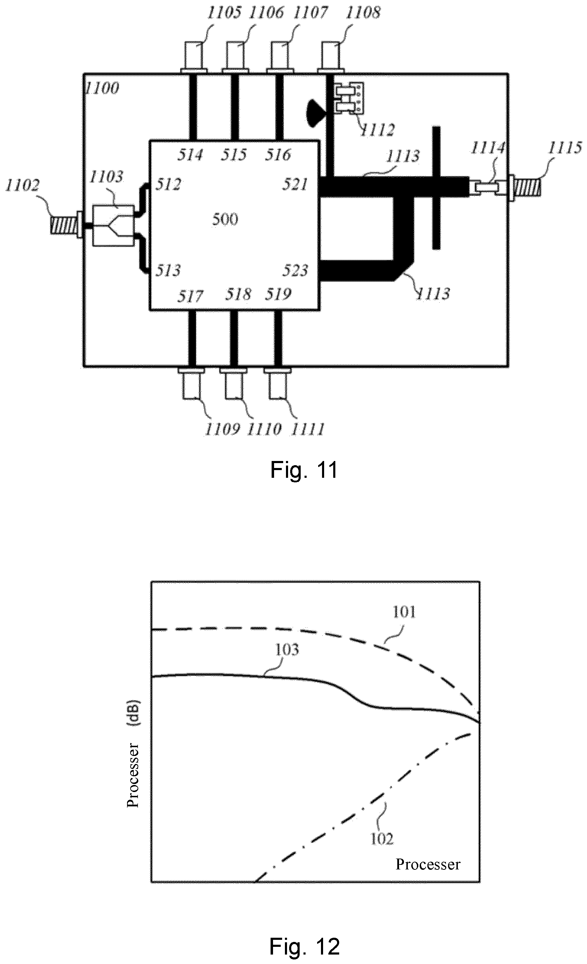

The other embodiments of the present disclosure further provide a signal amplifier comprising a carrier board and the package structure described in any one of the embodiments on the carrier board. Fig. 11 illustrates an example of a signal amplifier. As shown in Fig. 11, the signal amplifier comprises a carrier board 1100 and a package structure. In the example of Fig. 11, the package structure is the package structure 500 shown in Fig. 5. The first DC voltage input 514, the second DC voltage input 517, the third DC voltage input 515, the fourth DC voltage input 516, the fifth DC voltage input 518, and the sixth DC voltage input 519 of the package structure 500 are electrically connected via wires to corresponding peripheral terminals 1105, 1106, 1107, 1109, 1110, and 1111 of the signal amplifier, via which the package structure 500 can receive corresponding DC voltages. The signal amplifier further comprises a power divider 1103. The first signal input terminal 512 and the second signal input terminal 513 of the package structure 500 can be electrically connected respectively to the power divider 1103 via transmission lines. The power divider 1103 is electrically connected to a radio-frequency signal input terminal 1102. The output terminals 521 and 523 of the package structure 500 are electrically connected respectively to an output terminal 1115 of the signal amplifier via a transmission line 1113. The signal amplifier further comprises a capacitor 1112 and a capacitor 1114. A first end of the capacitor 1112 is electrically connected to a DC voltage terminal 1108 of the signal amplifier and a second end of the capacitor 1112 is electrically connected to the ground terminal. The capacitor 1112 can provide drain DC voltage to first transistor 504 and second transistor 505 in package structure 500. The capacitor 1114 is electrically connected between the signal output terminal 1115 and the transmission line 1113. In the example of Fig. 11, the capacitors 1112, 1114 and the transmission line 1113 further form an output signal combining network that combines the signals of the output terminals 521 and 523 of the package structure 500 to be output from the output terminal 1115 of the signal amplifier.

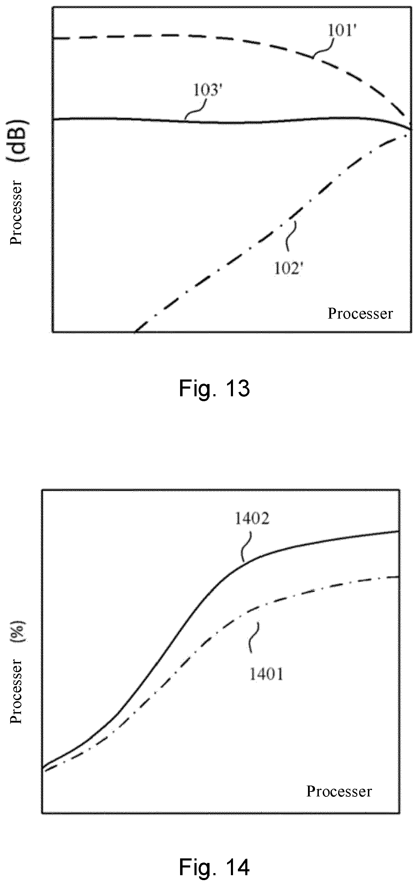

Figs. 12 to 14 illustrate the gain characteristics and efficiency characteristics of the signal amplifier with the package structure provided by the embodiment of the present disclosure. The "efficiency" referred to herein refers to the ratio of the output power of the output signal of the signal amplifier to the total DC power consumed by the signal amplifier. Fig. 13 and Fig. 14 respectively show gain characteristics and efficiency characteristics obtained by experimental tests based on the Doherty signal amplifier shown in Fig. 11. By comparison, Figs. 12 and 14 also illustrate gain characteristics and efficiency characteristics obtained based on the case where each transistor in the two signal amplifying paths in the package structure in the Doherty signal amplifier shown in Fig. 11 is respectively replaced by the first transistor 101 or the second transistor 102 shown in Fig. 1. As shown in Fig. 13, for the Doherty Amplifier shown in Fig. 11, the gain characteristic of the peak amplifying path is shown as 102', the gain characteristic of the main amplifying path is shown as 101', and the gain characteristic of the Doherty Amplifier as a whole is shown as 103'. It will be understood that the peak amplifying path can comprise the second transistor and the fourth transistor inside the first sub-package structure, and the main amplifying path can comprise the first transistor and the third transistor inside the first sub-package structure. If each transistor in the Doherty Amplifier shown in Fig. 11 is replaced with the first transistor 101 or the second transistor 102 shown in Fig. 1, the gain characteristics of the Doherty Amplifier are shown in Fig. 12, that is, the gain characteristics of the peak amplifying path, the main amplifying path and the Doherty Amplifier as a whole are respectively shown in 102, 101 and 103 in Fig. 12. As can be seen from Fig. 12 and Fig. 13, the overall gain characteristic 103' of the Doherty Amplifier shown in Fig. 13 has better flatness, in other words, the gain linearity of the signal amplifier is significantly improved. Further, as shown in Fig. 14, the efficiency of the Doherty signal amplifier based on Fig. 11 (as shown in 1402 in Fig. 14) is higher than that of the Doherty Amplifier with the first transistor 101 or the second transistor 102 as shown in Fig. 1 (as shown in 1401 in Fig. 14) due to the high power density and high efficiency of the gallium nitride transistor.

The signal amplifier with the package structure provided by the embodiment of the present disclosure has been described above by taking the Doherty Amplifier as an example, but the package structure provided by the embodiment of the present disclosure can also be employed for other types of power amplifiers, such as balanced amplifiers, outphasing power amplifiers, and the like.

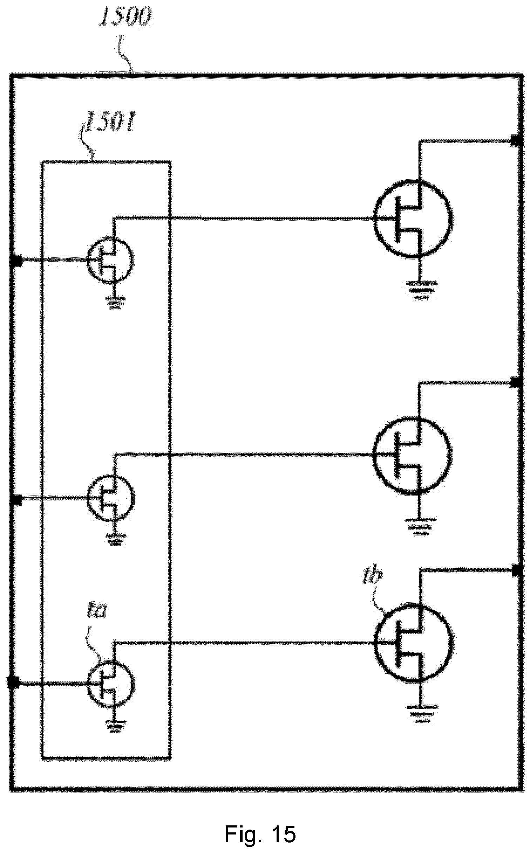

Further, although the package structure described in the previous embodiments comprises a first transistor, a second transistor, a third transistor, and a fourth transistor, which is an internal circuit of the package structure can comprise two signal amplifying paths. The first signal amplifying path comprises a third transistor and a first transistor, and the second signal amplifying path comprises a fourth transistor and a second transistor. In another embodiments, the package structure further comprises at least one first additional transistor and at least one second additional transistor corresponding to the at least one first additional transistor, i.e. the first additional transistor and the second additional transistor can form an additional signal amplifying path. As shown in Fig. 15, the first sub-package structure 1501 comprises the third transistor and the fourth transistor. An output terminal of each first additional transistor ta in the package structure 1500 is electrically connected to a control terminal of a corresponding second additional transistor tb, such that the corresponding second additional transistor tb can amplify a signal at the output terminal of the first additional transistor ta. The first additional transistor ta comprises a silicon-based transistor, the second additional transistor tb comprises a gallium nitride transistor, and the first additional transistor ta is integrated inside the first sub-package structure 1501. The signal amplifier with the package structure shown in Fig. 15 achieves similar technical effects to the aforementioned signal amplifier with the package structure shown in Fig. 2 and will not be described here.

It will be understood that although the first, second, third, and the like terms can be used herein to describe various devices, elements, components, or portions, such devices, elements, components, or portions should not be limited by these terms. These terms are used only to distinguish one device, element, component, or portion from another device, element, component, or portion. The "electrically connected" mentioned herein comprises "directly connected" or "indirectly connected". Although the technical aspects of the present application have been described in connection with some embodiments the scope of protection of the present application is not limited to the specific forms set forth herein. On the contrary, the scope of the present application is limited only by the appended claims.

## Claims

1. A package structure for signal amplification, comprising:
a substrate;
a first transistor on the substrate;
a second transistor on the substrate; and
a first sub-package structure on the substrate, the first sub-package structure comprising a third transistor and a fourth transistor, an output terminal of the third transistor and an output terminal of the fourth transistor being electrically connected respectively to a control terminal of the first transistor and a control terminal of the second transistor;
wherein each of the third transistor and the fourth transistor comprises a silicon-based transistor, and at least one of the first transistor and the second transistor comprises a gallium nitride transistor.

2. The package structure according to claim 1, wherein the package structure comprises a first signal input terminal and a second signal input terminal, and the first sub-package structure further comprises an input circuit;
wherein the input circuit is electrically connected, respectively to the first signal input terminal, the second signal input terminal, a control terminal of the third transistor, and a control terminal of the fourth transistor, to transmit AC signals input from the first signal input terminal and the second signal input terminal, respectively to the control terminal of the third transistor and the control terminal of the fourth transistor;
wherein the input circuit is further configured to transmit corresponding DC voltages respectively to the control terminal of the third transistor and the control terminal of the fourth transistor.

3. The package structure according to claim 2, wherein the package structure further comprises a first DC voltage input terminal and a second DC voltage input terminal, the input circuit comprising a first input sub-circuit and a second input sub-circuit, wherein the first input sub-circuit comprises:
a first capacitor and a first inductor electrically connected in series between the first signal input terminal and the control terminal of the third transistor;
a second inductor electrically connected between the control terminal of the third transistor and the first DC voltage input terminal; and
a second capacitor electrically connected between the first DC voltage input terminal and a ground terminal;
wherein the second input sub-circuit is symmetrical with the first input sub-circuit and electrically connected, respectively to the second signal input terminal, the second DC voltage input terminal, and the control terminal of the fourth transistor.

4. The package structure according to claim 1, wherein the package structure further comprises a second sub-package structure on the substrate, the second sub-package structure comprising an intermediate transmit circuit;
wherein the intermediate transmit circuit is electrically connected, respectively to an output terminal of the third transistor, an output terminal of the fourth transistor, a control terminal of the first transistor, and a control terminal of the second transistor, to transmit an output signal of the third transistor and an output signal of the fourth transistor respectively to the first transistor and the second transistor;
wherein the intermediate transmit circuit is further configured to transmit the corresponding DC voltage respectively to the output terminal of the third transistor, the output terminal of the fourth transistor, the control terminal of the first transistor and the control terminal of the second transistor.

5. The package structure according to claim 4, further comprising a third DC voltage input terminal, a fourth DC voltage input terminal, a fifth DC voltage input terminal, and a sixth DC voltage input terminal, wherein the intermediate transmit circuit comprises a first intermediate sub-circuit and a second intermediate sub-circuit, wherein the first intermediate sub-circuit comprises:
a third inductor and a third capacitor electrically connected in series between the output terminal of the third transistor and the control terminal of the first transistor;
a fourth inductor electrically connected between a node between the third inductor and the third capacitor and the third DC voltage input;
a fourth capacitor electrically connected between the third DC voltage input terminal and a ground terminal;
a fifth inductor electrically connected between a node between the third capacitor and the control terminal of the first transistor and the fourth DC voltage input terminal; and
a fifth capacitor electrically connected between the fourth DC voltage input terminal and a ground terminal;
wherein the second intermediate sub-circuit is symmetrical with the first intermediate sub-circuit and is electrically connected, respectively to the output terminal of the fourth transistor, the control terminal of the second transistor, the fifth DC voltage input terminal, and the sixth DC voltage input terminal.

6. The package structure according to claim 5, wherein the first intermediate sub-circuit further comprises:
a sixth capacitor electrically connected between the node between the third capacitor and the control terminal of the first transistor and the ground terminal;
a seventh sensor electrically connected between the node between the third capacitor and the control terminal of the first transistor and between the third capacitor; and
a seventh capacitor electrically connected between a node between the third capacitor and the seventh sensor and the ground terminal.

7. The package structure according to claim 4, further comprising a third sub-package structure and a signal output terminal on the substrate, the third sub-package structure comprising an output circuit;
wherein the output circuit is electrically connected to the signal output terminal, the output terminal of the first transistor, and the output terminal of the second transistor, respectively to combine and transmit a signal from the output terminal of the first transistor and the output terminal of the second transistor to the signal output terminal;
wherein the output circuit is further configured to transmit the corresponding DC voltage respectively to the control terminal of the first transistor and the control terminal of the second transistor.

8. The package structure according to claim 7, wherein the package structure further comprises a seventh DC voltage input terminal, and the output circuit comprises a transmission line, a first output capacitor, a first conductive node, and a second conductive node;
wherein a first end of the transmission line is electrically connected to the first conductive node via at least one first bond wire, the first conductive node is electrically connected to the output terminal of the first transistor via at least one second bond wire, a second end of the transmission line is electrically connected to the second conductive node via at least one third bond wire, a first end of the first output capacitor is electrically connected to the second conductive node via at least one fourth bond wire, a second end of the first output capacitor is electrically connected to the ground terminal, and the output terminal of the second transistor and the signal output terminal are electrically connected to the second conductive node respectively via at least one fourth bond wire and at least one fifth bond wire.

9. The package structure according to claim 8, wherein the transmission line comprises a stripline, a coplanar waveguide, a substrate integrated waveguide, or a microstrip line.

10. The package structure according to any one of claims 1 to 6, further comprising a signal output terminal, a second output capacitor, and a third conductive node on the substrate;
wherein the output terminal of the first transistor is electrically connected to the third conductive node via at least one sixth bond wire, the third conductive node, the output terminal of the second transistor, and the signal output terminal are electrically connected to a first end of the second output capacitor respectively via at least one seventh bond wire, at least one eighth bond wire and at least one ninth bond wire, and a second end of the second output capacitor is electrically connected to the ground terminal.

11. The package structure according to claim 4, wherein the intermediate transmit circuit comprises a first intermediate sub-circuit and a second intermediate sub-circuit;
wherein the first intermediate sub-circuit is configured to transmit an output signal of the third transistor to the first transistor, the second intermediate sub-circuit is configured to transmit an output signal of the fourth transistor to the second transistor, an output terminal of the first intermediate sub-circuit and an output terminal of the second intermediate sub-circuit are electrically connected to the first transistor and the second transistor respectively via at least one interstage bond wire;
wherein the intermediate transmit circuit comprises at least one sixth capacitor, a first end of the sixth capacitor is electrically connected to the ground terminal, and a second end of the sixth capacitor is electrically connected to the output terminal of the first intermediate sub-circuit or the output terminal of the second intermediate sub-circuit.

12. The package structure according to claim 7, wherein the package structure comprises a radio-frequency signal input terminal and the first sub-package structure further comprises a power divider;
wherein the power divider is electrically connected, respectively to the radio-frequency signal input terminal, the control terminal of the third transistor, and the control terminal of the fourth transistor, to respectively allocate the radio-frequency signal from the radio-frequency signal input terminal to the third transistor and the fourth transistor.

13. The package structure according to claim 1, wherein the package structure further comprises at least one first additional transistor and at least one second additional transistor corresponding to the at least one first additional transistor;
wherein an output terminal of each first additional transistor is electrically connected to a control terminal of a corresponding second additional transistor, so that the second additional transistor can amplify a signal at the output terminal of the first additional transistor;
wherein the first additional transistor comprises a silicon-based transistor, the second additional transistor comprises a gallium nitride transistor, and the first additional transistor is integrated within the first sub-package structure.

14. The package structure according to claim 1, wherein the package structure comprises a radio-frequency signal input terminal, and the first sub-package structure further comprises a power divider, wherein the power divider is electrically connected to the radio-frequency signal input terminal, a control terminal of the third transistor and a control terminal of the fourth transistor, respectively to allocate radio-frequency signals from the radio-frequency signal input terminal to the third transistor and the fourth transistor, respectively.

15. A signal amplifier comprising: a carrier board and the package structure according to any one of claims 1 to 9, 11 to 14 on the carrier board.
